# EUROPEAN PATENT APPLICATION

(11) **EP 4 310 892 A1**
(43) Date of publication of application: **24.01.2024**
(21) Application number: 22770881.5
(22) Date of filing: 27.01.2022
(51) Int. Cl.: H01L 21/66, G01R 1/067, G01R 1/073

(54) **PROBE AND PROBE CARD**

(30) Priority: 19.03.2021 JP 2021046038
(71) Applicant: Kabushiki Kaisha Nihon Micronics, Musashino-shi, Tokyo 180-8508 (JP)
(72) Inventor: NASU, Mika, Musashino-shi, Tokyo 180-8508 (JP); TOYODA, Misaki, Musashino-shi, Tokyo 180-8508 (JP); KON, Mizuho, Musashino-shi, Tokyo 180-8508 (JP); SUTO, Kenichi, Musashino-shi, Tokyo 180-8508 (JP); HAYASHIZAKI, Takayuki, Musashino-shi, Tokyo 180-8508 (JP)
(74) Representative: Samson & Partner Patentanwälte mbB
(86) International application number: PCT/JP2022/003027
(87) International publication number: WO 2022/196119

(57) **Abstract**

A probe is inserted into a through-hole in a guide plate and used for inspecting electrical characteristics of an inspection object, and the probe includes: a columnar conductor; and a plurality of insulating coating materials arranged spaced apart from each other on a surface of the conductor along a central axis direction of the conductor.

## Description

### TECHNICAL FIELD

The present invention relates to a probe and a probe card used for inspecting the electrical characteristics of an inspection object.

### BACKGROUND ART

In order to inspect the electrical characteristics of an inspection object, such as a semiconductor integrated circuit, in a state in which the inspection object is not separated from the wafer, a probe card having a probe that comes into contact with the inspection object is used (see Patent Literature 1). In a probe card, a probe is arranged at a position corresponding to an inspection pad of an inspection object. Thus, when the distance between inspection pads becomes small due to reduction in the size of a semiconductor integrated circuit, the distance between probes also becomes small. When the distance between probes becomes small, the adjacent probes may come into contact with each other when the probes are curved in the space inside a probe head during inspection of an inspection object. For this reason, a method has been used of disposing a guide film in the space inside a probe head such that the probes can penetrate the guide film and be held in the space.

### CITATION LIST

### PATENT LITERATURE

Japanese Unexamined Patent Application Publication No. 2015-118064

### SUMMARY OF THE INVENTION

### TECHNICAL PROBLEM

Resin or the like is used as a material for a guide film. For this reason, a guide film is easily deformed. Moreover, since resin is easily deformed by heat, a guide film is easily distorted by thermal deformation. When a guide film is deformed, a probe which has penetrated through a through-hole formed in the guide film is inhibited from sliding inside a probe head. This causes poor contact between a probe and an inspection pad, or prevents a probe from returning from a state in which the probe has been brought into contact with the inspection pad to a state of being spaced apart from the inspection pad. Thus, the use of a guide film in a probe head inhibits a probe from moving. An object of the present invention is to provide a probe and a probe card that suppress a short circuit between probes and do not inhibit the probe from moving in a probe head.

### TECHNICAL SOLUTION

A probe according to an aspect of the present invention is inserted into a through-hole in a guide plate and used for inspecting electrical characteristics of an inspection object, and the probe includes: a columnar conductor; and a plurality of insulating coating materials arranged spaced apart from each other on a surface of the conductor along a central axis direction of the conductor.

### ADVANTAGEOUS EFFECT OF THE INVENTION

The present invention makes it possible to provide a probe and a probe card that suppress a short circuit between probes and do not inhibit the probe from moving in a probe head.

### BRIEF DESCRIPTION OF THE DRAWINGS

[FIG. 1] FIG. 1 is a schematic diagram illustrating a configuration of a probe according to an embodiment of the present invention.
[FIG. 2] FIG. 2 is a schematic cross-sectional diagram of a conductor of the probe perpendicular to a central axis direction according to the embodiment of the present invention.
[FIG. 3] FIG. 3 is a schematic diagram illustrating a configuration of a probe card having the probe according to the embodiment of the present invention.
[FIG. 4] FIG. 4 is a schematic diagram illustrating an example of an arrangement of the probes arranged in a probe head.
[FIG. 5] FIG. 5 is a schematic diagram illustrating a configuration of probes and a probe head in a comparative example.
[FIG. 6] FIG. 6 is a schematic diagram illustrating how the probe is inserted into a guide hole in a guide plate.
[FIG. 7] FIG. 7 is a schematic diagram illustrating the shape of coating material in the comparative example.
[FIG. 8] FIG. 8 is a schematic diagram illustrating an obstruction when inserting the probe with the coating material of the comparative example arranged thereon into the guide hole in the guide plate.
[FIG. 9] FIG. 9 is a schematic diagram illustrating a modified example of the shape of coating material of the probe according to the embodiment of the present invention (part 1).
[FIG. 10] FIG. 10 is a schematic diagram illustrating modified examples of shapes of coating material of the probe according to the embodiment of the present invention (part 2).
[FIG. 11] FIG. 11 is a schematic diagram illustrating modified examples of shapes of coating material of the probe according to the embodiment of the present invention (part 3).
[FIG. 12] FIG. 12 is a schematic diagram illustrating modified examples of shapes of coating material of the probe according to the embodiment of the present invention (part 4).
[FIG. 13] FIG. 13 is a schematic diagram illustrating other modified examples of shapes of coating material of the probe according to the embodiment of the present invention (part 1).
[FIG. 14] FIG. 14 is a schematic diagram illustrating other modified examples of shapes of coating material of the probe according to the embodiment of the present invention (part 2).
[FIG. 15] FIG. 15 is a schematic diagram illustrating an example of a method of forming coating material of the probe according to the embodiment of the present invention.
[FIG. 16] FIG. 16 is a schematic diagram illustrating structures of coating material of a probe according to a modified example of the embodiment of the present invention.
[FIG. 17] FIG. 17 is a schematic diagram illustrating examples of shapes of coating material of a probe according to a modified example of the embodiment of the present invention.
[FIG. 18] FIG. 18 is a schematic diagram illustrating examples of arrangements of coating material of a probe according to a modified example of the embodiment of the present invention.
[FIG. 19] FIG. 19 is a schematic diagram illustrating structures of coating material of a probe according to another modified example of the embodiment of the present invention.
[FIG. 20] FIG. 20 is a schematic diagram illustrating examples of shapes of coating material of a probe according to another modified example of the embodiment of the present invention.
[FIG. 21] FIG. 21 is a schematic diagram illustrating examples of arrangements of coating material of a probe according to another modified example of the embodiment of the present invention.
[FIG. 22A] FIG. 22A is a schematic diagram illustrating a configuration of a probe according to another embodiment of the present invention.
[FIG. 22B] FIG. 22B is a schematic diagram illustrating another configuration of a probe according to another embodiment of the present invention.

### DESCRIPTION OF EMBODIMENTS

Embodiments of the present invention will be described below with reference to the drawings. The same elements illustrated in the drawings are denoted by the same reference numerals, and overlapping descriptions are not repeated below. The drawings are illustrated schematically, and it should be noted that the proportions of the thicknesses of the respective parts and so forth are not drawn to scale. It should also be understood that the relationships or proportions of the dimensions between the respective drawings can differ from each other. The embodiments described below exemplify a device and a method for embodying the technical idea of the present invention. In the embodiments of the present invention, the material, shape, structure, arrangement, manufacturing method and the like of the components are not limited to the following description.

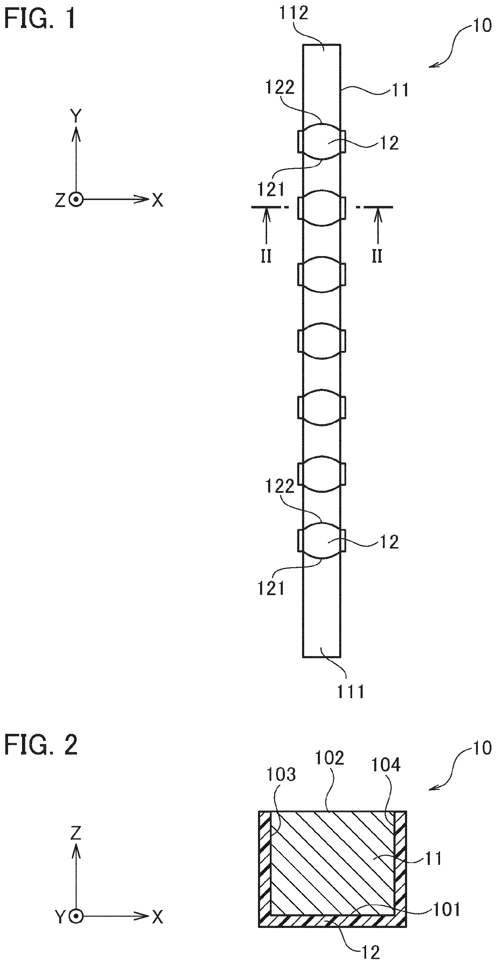

A probe 10 according to an embodiment illustrated in FIG. 1 is used for inspecting the electrical characteristics of an inspection object. The probe 10 includes a columnar conductor 11 having a rectangular cross-sectional shape perpendicular to the central axis direction, and a plurality of insulating coating materials 12 arranged spaced apart from each other on at least one surface of the conductor 11 along the direction of the central axis of the conductor 11.

FIG. 2 illustrates a cross-section perpendicular to the direction of the central axis (hereafter also referred to simply as a "central axis direction"), of the conductor 11. FIG. 2 illustrates a cross-sectional diagram along the II-II direction of FIG. 1. The cross-section of the probe 10 has a rectangular shape defined by a first surface 101, a second surface 102 facing the first surface 101, a first side surface 103 and a second side surface 104 each connecting to the first surface 101 and the second surface 102. In the probe 10 illustrated in FIG. 2, the coating material 12 is arranged on the surface of the conductor 11 from the first side surface 103 to the second side surface 104 across the first surface 101.

In the drawings, the Y-axis direction is the central axis direction of the conductor 11. The central axis direction is parallel to the direction in which the probe 10 is inserted into a probe head, as described later. The X-axis direction is the width direction of the first surface 101 of the conductor 11 which is perpendicular to the Y-axis direction. The Z-axis direction is the direction normal to the plane of the first surface 101, and the thickness direction of the coating material 12.

The cross-sectional area perpendicular to the central axis direction, of the end surface of the coating material 12 that faces at least one end of the conductor 11 (hereafter also referred to as an "area of an end surface") becomes gradually wider as the distance from the portion closest to the end of the conductor 11 increases along the central axis direction. The coating material 12 of the probe 10 illustrated in FIG. 1 has an elliptical shape with both ends missing when viewed from the direction normal to the plane of the first surface 101 (hereafter also referred to as "plan view"). For this reason, in the probe 10, the area of a first end surface 121 of the coating material 12 facing a first end 111 of the conductor 11 becomes gradually wider along the central axis direction from the portion closest to the first end 111. Further, the area of a second end surface 122 of the coating material 12 facing a second end 112 of the conductor 11 becomes gradually wider along the central axis direction from the portion closest to the second end 112.

In the following description, one or both of the first end surface 121 and the second end surface 122 of the coating material 12 is also referred to as an "end surface". In addition, one or both of the first end 111 and the second end 112 of the conductor 11 is also referred to as an "end".

In order to describe the function of the probe 10, a probe card including a probe head for holding the probe 10 will be described below.

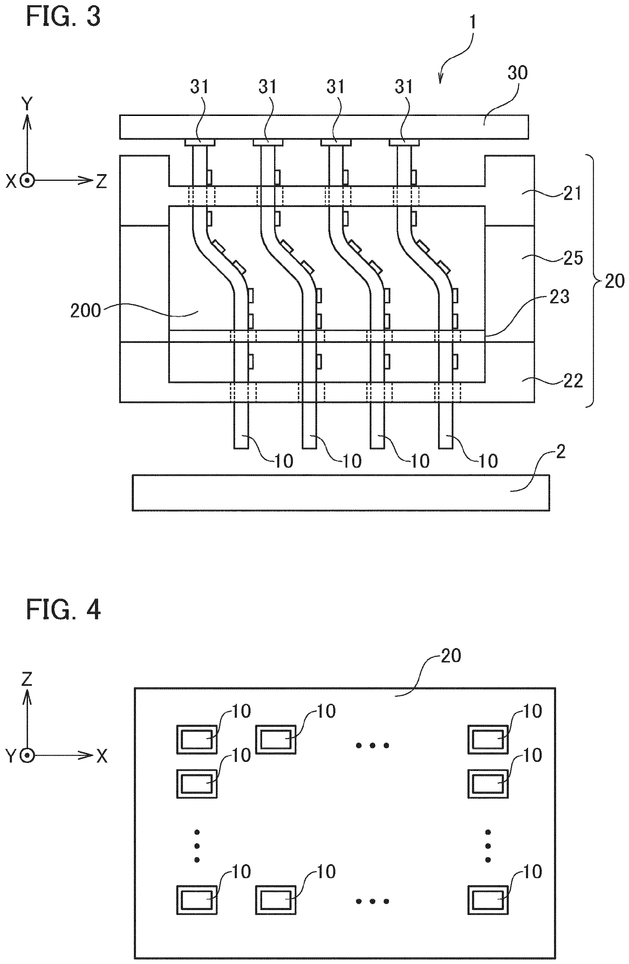

FIG. 3 illustrates a probe card 1 provided with the probes 10. The probe card 1 is used to inspect the characteristics of an inspection object 2. The inspection object 2 is, for example, a semiconductor integrated circuit formed on a semiconductor substrate. The probe card 1 includes a probe head 20 that holds the probes 10 with the first ends 111 facing the inspection object 2, and a wiring board 30. In FIG. 3, the number of probes 10 held by the probe head 20 is four; however, needless to say, the number of probes 10 is not limited to four.

As illustrated in FIG. 3, the probe 10 penetrates the probe head 20. The second end 112 of the probe 10 is connected to a land 31 arranged on the wiring board 30. The land 31 is made of a conductive material such as metal, and an inspection device such as a tester (not illustrated) and the land 31 are electrically connected to each other. An electrical signal propagates between the inspection device and the inspection object 2 via the probe card 1. The wiring board 30 is, for example, a printed circuit board (PCB) or an interposer (IP) board.

The probe head 20 has a plurality of guide plates in which through-holes (hereafter also referred to as "guide holes") through which the probes 10 penetrate are formed. The probe head 20 illustrated in FIG. 3 has a top guide plate 21 facing the wiring board 30, a bottom guide plate 22 facing the inspection object 2, and an MGC guide plate 23 arranged between the top guide plate 21 and the bottom guide plate 22. The MGC guide plate 23 is arranged close to the bottom guide plate 22. By arranging a spacer 25 between the outer edge region of the top guide plate 21 and the outer edge region of the bottom guide plate 22, an intermediate region 200 is formed inside the probe head 20 between the top guide plate 21 and the MGC guide plate 23. The spacer 25 of the probe head 20 is an insulating material such as ceramic or a metallic material, and the same applies to the guide plates.

When viewed from the direction normal to the plane of the main surfaces of the guide plates in which the openings of the guide holes are formed, the positions of the guide holes of the top guide plate 21 through which the same probes 10 penetrate and the positions of the guide holes of the bottom guide plate 22 and the MGC guide plate 23 are offset in the direction parallel to the main surface. Since the guide holes are arranged in this way (an offset arrangement), the probes 10 bend in the intermediate region 200 due to the elastic deformation. For this reason, the probes 10 buckle when coming into contact with the inspection object 2, and thus the probes 10 come into contact with the inspection object 2 at a prescribed pressure.

As illustrated in FIG. 4, for example, the probes 10 are arranged in a matrix when viewed from the direction normal to the plane of the main surfaces of the guide plates. However, the arrangement of the probes 10 is not limited to a matrix. The number of probes 10 held by one probe head 20 ranges from hundreds to tens of thousands in some cases. Due to the progress in the integration of semiconductor integrated circuits and other factors, the distance between inspection pads is becoming smaller, and thus the distance between the probes 10 also becomes smaller. Therefore, there is a high possibility that the adjacent probes 10 will come into contact with each other.

In contrast, the insulating coating material 12 is arranged on the surfaces of the probes 10. For this reason, even if the probes 10 come into contact with each other in a case where the probes 10 buckle in the intermediate region 200, the conductor 11 of one probe 10 comes into contact with the coating material 12 of the other probe 10. This makes it possible to suppress a short circuit between the probes 10 caused by the contact between the conductors 11 of the probes 10.

The coating materials 12 are not arranged so as to be continuous on the surfaces of the probes 10 along the central axis direction, and the plurality of coating materials 12 are arranged spaced apart from each other along the central axis direction of the conductor 11. This makes it possible to suppress warpage of the probes 10 caused by the coating materials 12 being arranged so as to be continuous on the surfaces of the probes 10.

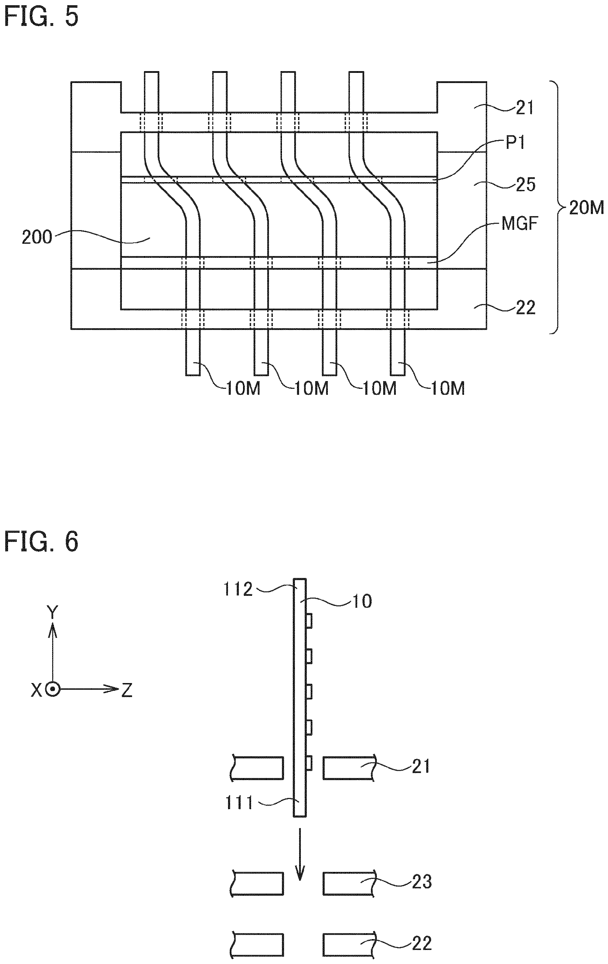

In contrast, in a probe head 20M of a probe card of a comparative example illustrated in FIG. 5, a guide film PI and a guide film MGF are arranged between a top guide plate 21 and a bottom guide plate 22. Then, a short circuit between the probes 10M is suppressed by penetrating the probes 10M into the guide holes of the guide film PI and the guide film MGF. However, as already described above, the use of an easily deformable guide film for the probe head 20M inhibits the probes 10M from sliding. On the other hand, with the probes 10 having a configuration in which the coating materials 12 are arranged on the surfaces of the conductors 11, a short circuit between the probes 10 is suppressed without using guide films. Accordingly, the probe card 1 in which the probes 10 are used does not inhibit the probes 10 from moving in the probe head 20.

Incidentally, in order to set the probes 10 in the probe head 20, the probes 10 are made to penetrate the guide holes in the guide plates. For example, in a state in which the center axes of the guide holes of all the guide plates are aligned, the probes 10 are made to continuously penetrate the top guide plate 21, the MGC guide plate 23, and the bottom guide plate 22 in this order, as illustrated by the arrows in FIG. 6. At this time, the probes 10 are inserted into the guide holes in the guide plates from the first end 111 side, as illustrated in FIG. 6.

If the distance (clearance) between the inner walls of the guide holes in the guide plates and the outer edges of the probes 10 increases excessively, the positions of the probes 10 become unstable inside the guide holes. As a result, the alignment accuracy between the probes 10 and the inspection object decreases. Therefore, a narrow clearance is preferable, and the clearance is set to about 2 to 5 microns, for example.

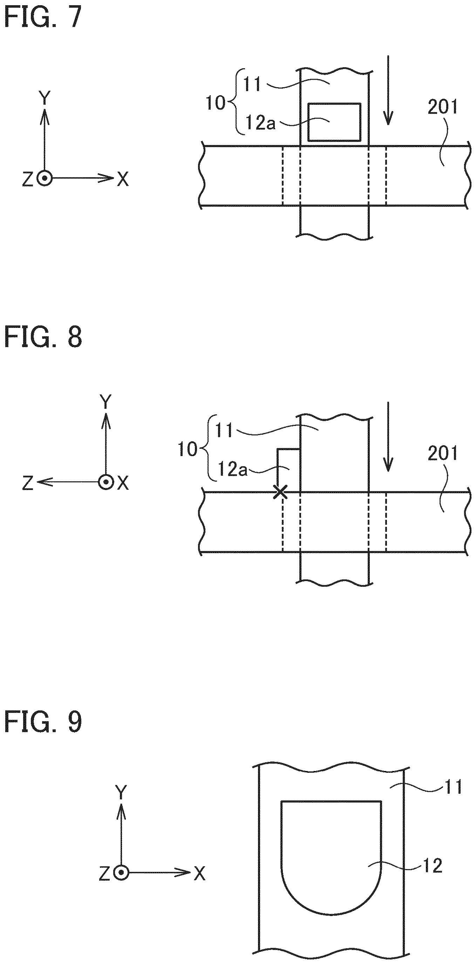

However, in the probe 10 with the coating material 12 arranged on the surface, the coating material 12 tends to collide with the guide plates when the probe 10 is inserted into the guide holes. In particular, when the shape of the coating material 12 in plan view (hereafter also referred to simply as a "shape") is square as in the coating material 12a of a comparative example illustrated in FIG. 7, the portion of the coating material 12a approaching the guide plate 201 is one side of the square. That is, when the probe 10 approaches the guide plate 201 as illustrated by the arrow, the area of the coating material 12a facing the guide plate has a fixed area. For this reason, as illustrated by the cross mark in FIG. 8, the end surface of the coating material 12a collides with the periphery of the guide holes in the guide plate 201, resulting in an obstruction that inhibits the probe 10 from being inserted into the guide holes. For example, the coating material 12 is likely to collide with the guide plate 201 as the clearance becomes narrow.

In contrast, the end surface of the coating material 12 of the probe 10 has a curved shape. For this reason, the area of the first end surface 121 of the coating material 12 facing the first end 111 gradually becomes wider as the distance from the portion closest to the first end 111 increases along the central axis direction of the conductor 11. Thus, since the end surface of the coating material 12 is curved in plan view, the region approaching the guide plate of the coating material 12 has a dot shape in plan view. That is, even if the first end surface 121 of the coating material 12 collides with the guide plate, the surfaces of the first end surface 121 and the guide plate do not collide with faces. Accordingly, the probe 10 continues to move without the coating material 12 getting caught in the probe head 20. Thus, it is possible to prevent the movement of the probe 10 from being inhibited due to the end surface of the coating material 12 colliding with the guide plate.

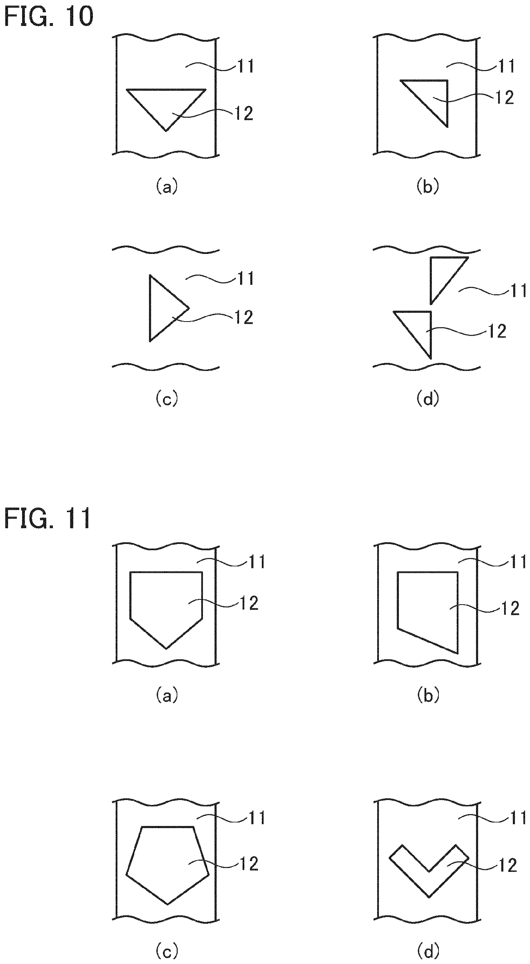

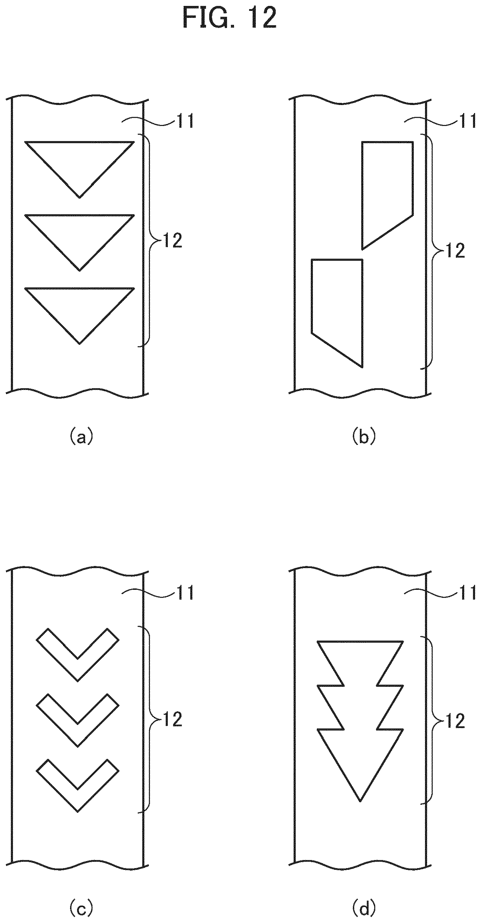

The case where the coating material 12 has an elliptical shape has been described above. However, the coating material 12 is not limited to having an elliptical shape as long as having a shape in which the area of the end surface facing at least one end of the conductor 11 becomes gradually wider. For example, as illustrated in the modified example of FIG. 9, the coating material 12 may have a one-sided circular shape in which the end surface facing one end of the conductor 11 is curved and the end surface facing the other end thereof is flat. Further, the coating material 12 may have a triangular shape with an apex arranged facing the end of the conductor 11, as illustrated in the modified examples of FIG. 10(a) to FIG. 10(d). The coating material 12 may have a shape with a plurality of triangles arranged, as illustrated in FIG. 10(d). Furthermore, the coating material 12 may have a polygonal shape with an apex arranged facing the end of the conductor 11, as illustrated in the modified examples of FIG. 11(a) to FIG. 11(d). In addition, the coating material 12 may have a shape in which a plurality of triangles or polygons are combined, as illustrated in the modified examples of FIG. 12(a) to FIG. 12(d).

As described above, the coating material 12 may have a polygonal shape, and the end surface of the coating material 12 facing the end of the conductor 11 may have an inclined shape diagonally intersecting the central axis direction. Since the end surface has an inclined shape and the portion closest to the end is an apex of the polygonal shape in plan view, the area of the end surface facing the end becomes gradually wider.

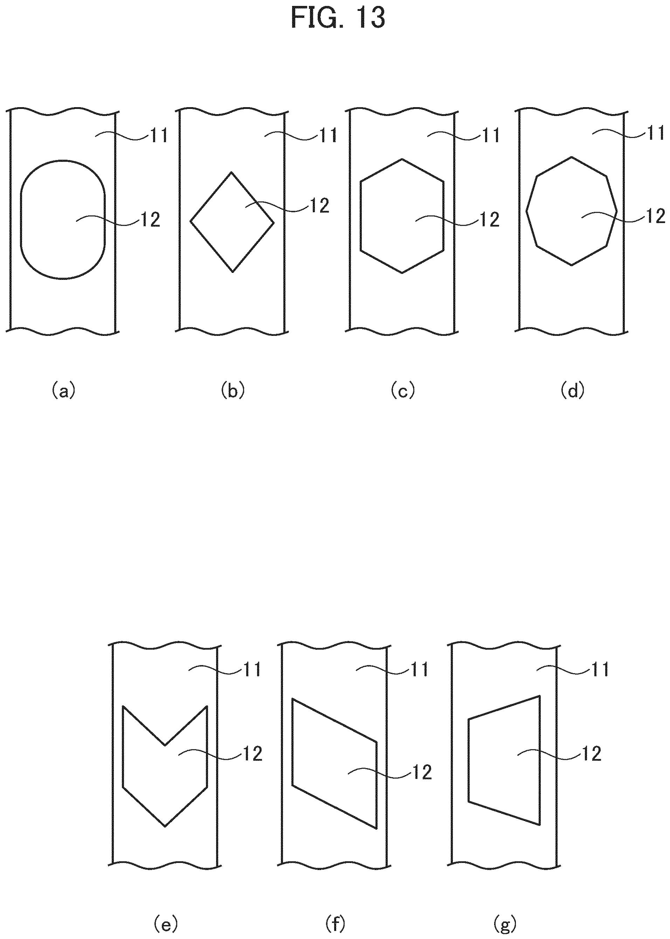

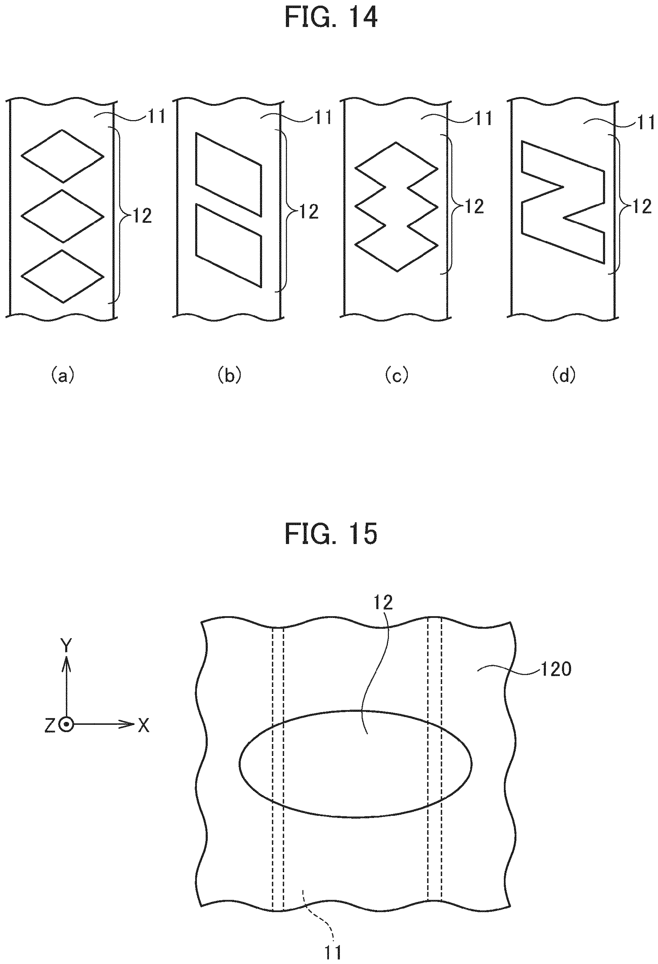

In the above modified examples, since one end surface of the coating material 12 has an inclined shape diagonally intersecting the central axis direction or a curved shape, it is possible to prevent the movement of the probe 10 from being inhibited due to the coating material 12 coming into contact with the guide plates when the probe 10 is inserted into the guide holes. Further, since both end surfaces of the coating material 12 have a curved shape or an inclined shape, it is also possible to prevent the movement of the probe 10 from being inhibited due to the coating material 12 coming into contact with the guide plates when the probe 10 is removed from the guide holes. For example, when the probe 10 is inserted into the guide holes in the guide plates from the first end 111 side and the probe 10 is removed from the guide hole in the guide plate from the second end 112 side, it is possible to prevent the movement of the probe 10 from being inhibited. FIG. 13(a) to FIG. 13(g) illustrate modified examples in which both end surfaces of the coating material 12 are curved or inclined. As illustrated in FIG. 14(a) to FIG. 14(d), the coating material 12 may have a shape in which a plurality of polygons are combined.

As described above, the probe 10 according to the embodiment makes it possible to suppress a short circuit between the probes 10 by arranging the coating material 12 on the surface of the conductor 11. Further, the end surface of the coating material 12 that first comes close to the guide plate has a curved shape or an inclined shape when the probe 10 is inserted into the guide holes in the guide plates, thereby making it possible to prevent the movement of the probe 10 from being inhibited due to the coating material 12 coming into contact with the guide plates.

The material of the conductor 11 may be a metallic material such as nickel (Ni), iron (Fe), or cobalt (Co), for example. Alternatively, the material of the conductor 11 may be an alloy containing these metals, for example. The coating material 12 may be resins, glass fibers, a permanent resist, a ceramic deposit, or the like, for example.

In order to form a specific shape of the coating material 12 at a predetermined position on the surface of the conductor 11, the coating material 12 is patterned after the coating material 12 is formed on the surface of the conductor 11. For example, by means of a photolithography technique using a photomask 120 formed with an elliptical pattern as illustrated in FIG. 15, the pattern formed on the photomask 120 is transferred onto a permanent resist formed on the first surface 101 of the conductor 11. In the elliptical pattern on the photomask 120 illustrated in FIG. 15, both ends of the ellipse protrude from the first surface 101. The permanent resist formed on the first side surface 103 and the second side surface 104 of the conductor 11 is patterned by this protruding ellipse exposed at both ends. The coating material 12, such as resins, glass fibers, or a ceramic deposit, may be formed on the surface of the conductor 11 by a photolithography technique.

A short circuit between the probes 10 can be suppressed as the distance between the coating materials 12 decreases along the central axis direction. In the central axis direction, the length of the coating materials 12 and the distance between them can be discretionally set according to the thickness and material of the conductor 11 to the extent that no warpage occurs in the probe 10. In addition, the thickness of the coating material 12 is set to a thickness that can suppress a short circuit between the probes 10 to the extent that the clearance between the guide holes and the probe 10 can be ensured.

### <Modified Examples>

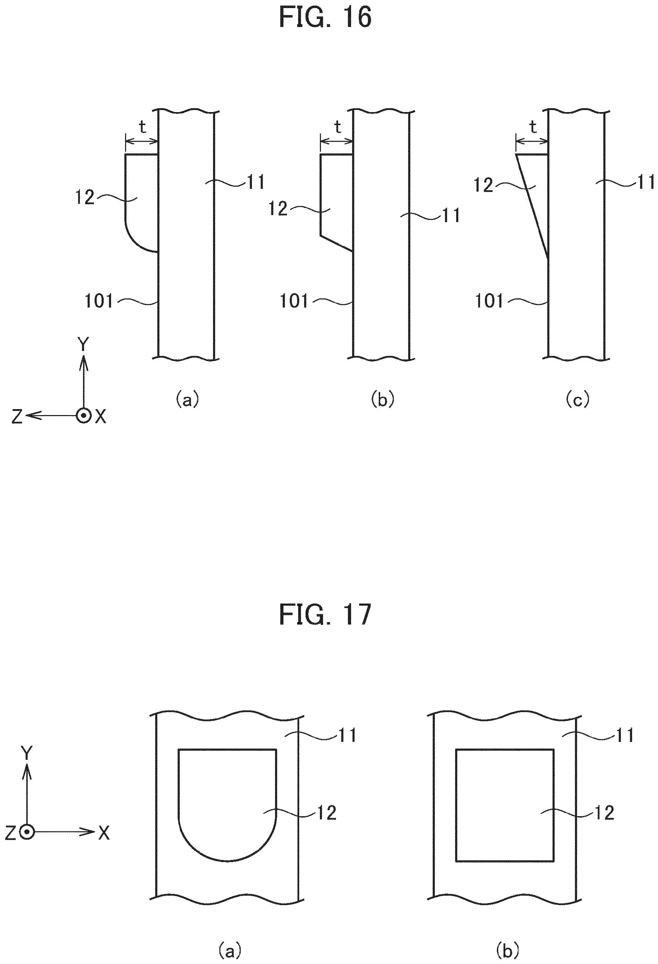

A structure of the coating material 12 of the probe 10 according to modified examples of the embodiment of the present invention will be illustrated in FIG. 16(a) to FIG. 16(c). FIG. 16(a) to FIG. 16(c) illustrate side views of the coating material 12 as viewed from the direction perpendicular to the direction normal to the plane of the first surface 101 (hereafter also referred to as "lateral view"). As illustrated in FIG. 16(a) to FIG. 16(c), in the probe 10 according to modified examples of the embodiment, the portion of the coating material 12 that is closest to the end of the conductor 11 comes into contact with the surface of the conductor 11. Then, a thickness t of the coating material 12 gradually increases as the distance from the end of the conductor 11 increases. The end surface of the coating material 12 illustrated in FIG. 16(a) has a curved shape in lateral view. The coating material 12 illustrated in FIG. 16(b) has a trapezoidal shape in which the end surface is inclined along the central axis direction in side view. The coating material 12 illustrated in FIG. 16(c) has a triangular shape in which the end surface is inclined along the central axis direction in side view.

The shape of the coating material 12 of the probe 10 in plan view is discretionary in the modified examples. For example, the end surface of the coating material 12 may have a curved shape as illustrated in FIG. 17(a), or the coating material 12 may have a rectangular shape as illustrated in FIG. 17(b).

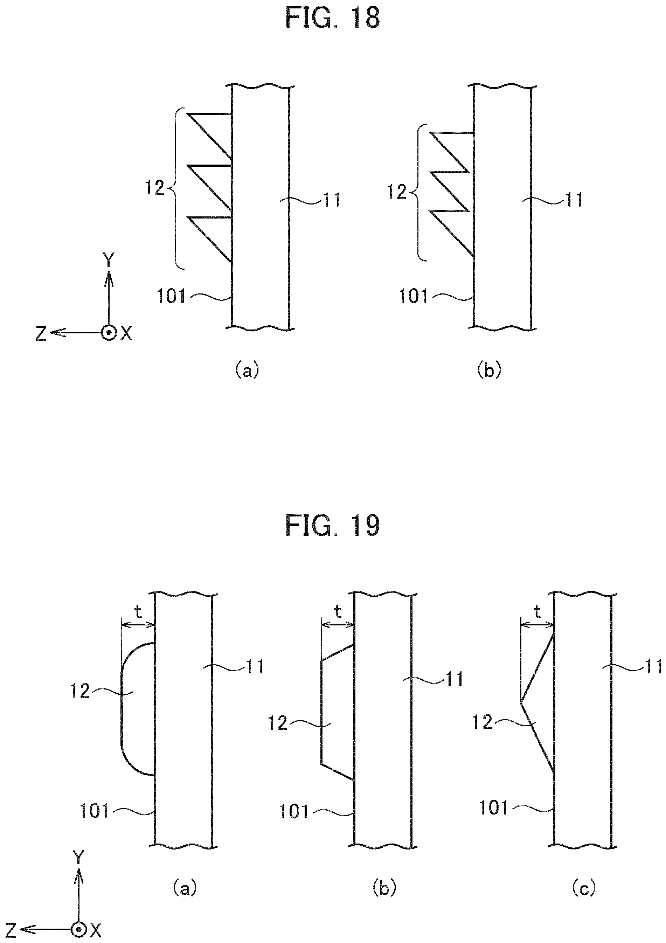

In addition, a plurality of coating materials 12 may be arranged in the central axis direction as illustrated in FIG. 18(a) and FIG. 18(b). FIG. 18(a) illustrates an example of a configuration in which a plurality of coating materials 12 are arranged spaced apart from each other. FIG. 18(b) illustrates an example of a configuration in which a plurality of coating materials 12 are arranged by being connected with each other.

The above description has been given regarding the coating material 12 in which the thickness t of the coating material 12 gradually increases as the distance from the end of the conductor 11 increases. This makes it possible to prevent the movement of the probe 10 from being inhibited due to the coating material 12 coming into contact with the guide plates, for example, when the probe 10 is inserted into the guide holes in the guide plates.

Further, since both end surfaces of the coating material 12 have the thickness t gradually increasing as the distance from the end of the conductor 11 increases, it is also possible to prevent the movement of the probe 10 from being inhibited due to the coating material 12 coming into contact with the guide plates when the probe 10 is removed from the guide holes. FIG. 19(a) to FIG. 19(c) illustrate modified examples in which the thickness t of both end surfaces of the coating material 12 gradually increases from the portion close to the end. Both end surfaces of the coating material 12 illustrated in FIG. 19(a) have a curved shape in lateral view. The coating material 12 illustrated in FIG. 19(b) has a trapezoidal shape in lateral view, and the end surfaces are inclined along the central axis direction. The coating material 12 illustrated in FIG. 19(c) has a triangular shape in lateral view, and the end surfaces are inclined along the central axis direction.

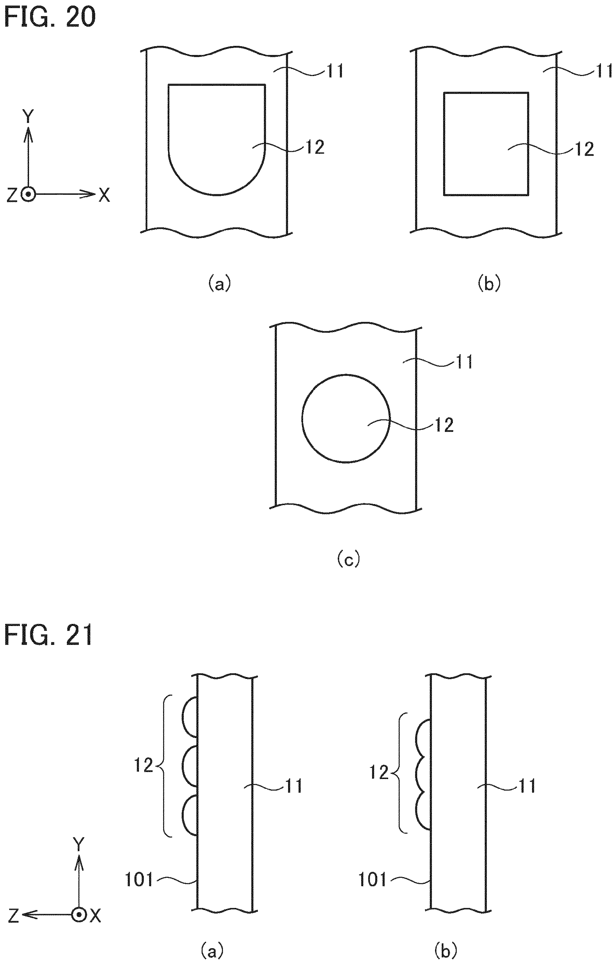

The shape of the coating material 12 of the probe 10 in plan view is also discretionary, even in the modified examples of FIG. 19(a) to FIG. 19(c). For example, the coating material 12 may have a one-sided circular shape in plan view as illustrated in FIG. 20(a), a rectangular shape in plan view as illustrated in FIG.

### 20(b), or a circular shape in plan view as illustrated in FIG. 20(c).

In addition, a plurality of coating materials 12 may be arranged in the central axis direction as illustrated in FIG. 21(a) and FIG. 21(b). FIG. 21(a) illustrates an example of a configuration in which a plurality of semi-circular coating materials 12 are arranged spaced apart from each other in lateral view. FIG. 21(b) illustrates an example of a configuration in which a plurality of semi-circular coating materials 12 are arranged by being connected with each other in lateral view.

### (Other Embodiments)

The embodiments of the present invention have been described above, but the statements and drawings forming part of this disclosure should not be understood as limiting the invention. Various alternative embodiments, examples, and operating techniques will be apparent to those skilled in the art from this disclosure.

For example, in the above description, the coating materials 12 are arranged on three surfaces or one surface of the probe 10 having a rectangular cross-section, but the coating materials 12 may be arranged on two or four surfaces of the probe 10. The coating materials 12 are arranged on at least one surface of the probe 10, and thus a short circuit between the probes 10 can be suppressed.

In addition, although the description has been given regarding the case where the probe 10 has a rectangular cross-sectional shape perpendicular to the central axis direction, the probe 10 may have other cross-sectional shapes. For example, the cross-sectional shape of the probe 10 may have a circular shape, or a polygonal shape other than a rectangular shape.

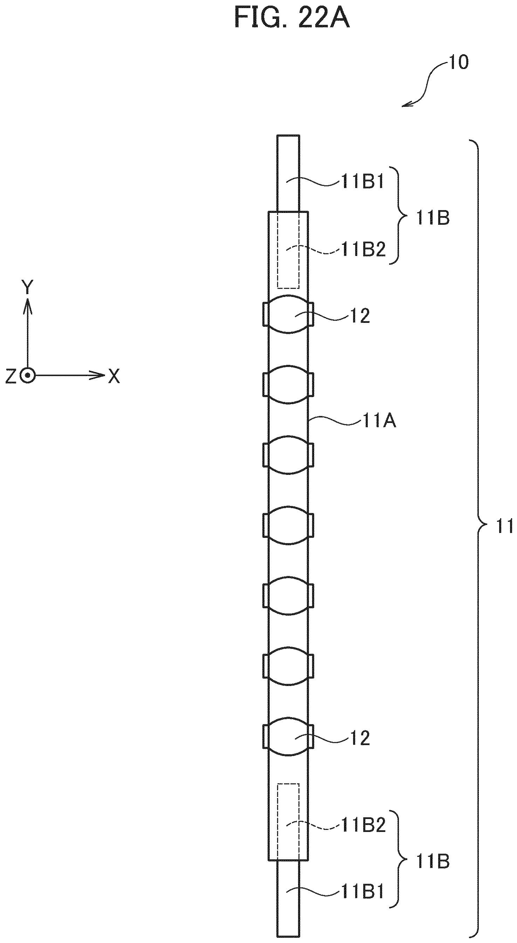

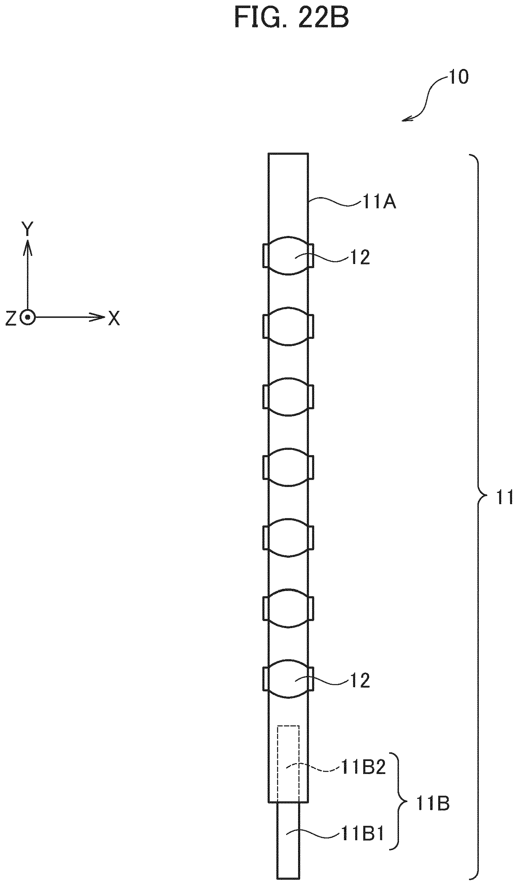

In addition, as illustrated in FIG. 22A, the conductor 11 of the probe 10 may have a structure having a tube-shaped barrel 11A and a plunger 11B that is inserted into the open end of the barrel 11A. The coating materials 12 are arranged on the surface of the barrel 11A, for example. The plunger 11B is rod-shaped with an insertion part 11B2 inserted inside the barrel 11A and a distal end 11B1 connected to the insertion part 11B2. In the probe 10 illustrated in FIG. 22A, for example, the distal end 11B1 of one plunger 11B may be brought into contact with an inspection object, and the distal end 11B1 of the other plunger 11B may be brought into contact with the land. Although the probe 10 illustrated in FIG. 22A has a structure in which the respective plungers 11B are inserted into the open ends at both ends of the barrel 11A, the probe 10 may have a structure in which the plunger 11B is inserted into only one open end of the barrel 11A as illustrated in FIG. 22B. In the probe 10 illustrated in FIG. 22B, for example, the distal end 11B1 of the plunger 11B may be brought into contact with an inspection object, and the end of the barrel 11A on the side where the plunger 11B is not inserted may be brought into contact with the land.

It should be understood that the present invention includes various embodiments not described herein.

## Claims

1. A probe that is inserted into a through-hole in a guide plate and used for inspecting electrical characteristics of an inspection object, comprising:
a columnar conductor; and
a plurality of insulating coating materials arranged spaced apart from each other on a surface of the conductor along a central axis direction of the conductor.

2. The probe according to claim 1, wherein
a cross-sectional area perpendicular to the central axis direction, of an end surface of each coating material that faces at least one end of the conductor becomes gradually wider as a distance from a portion closest to the end increases along the central axis direction.

3. The probe according to claim 2, wherein
the cross-sectional area of the each end surface facing two ends of the conductor becomes gradually wider as the distance from the portion closest to the end increases along the central axis direction.

4. The probe according to claim 2 or 3, wherein
a cross-section perpendicular to the central axis direction, of the conductor has a rectangular shape defined by a first surface, a second surface facing the first surface, and a first side surface and a second side surface each connecting to the first surface and the second surface, and
each coating material is arranged on at least one surface of the conductor.

5. The probe according to claim 4, wherein
each coating material is arranged from the first side surface to the second side surface across the first surface.

6. The probe according to claim 2 or 3, wherein
the end surface of each coating material has a curved shape when viewed from a direction normal to a plane of the surface on which each coating material is arranged.

7. The probe according to claim 2 or 3, wherein
the portion closest to the end, of the end surface of each coating material is an apex of a polygonal shape when viewed from a direction normal to a plane of the surface on which each coating material is arranged.

8. The probe according to claim 7, wherein
each coating material has a shape in which a plurality of polygons are combined when viewed from the direction normal to the plane.

9. The probe according to claim 2 or 3, wherein
the portion closest to the end, of each coating material comes into contact with the surface of the conductor, and a thickness of each coating material at the end surface gradually increases as a distance from the end of the conductor increases.

10. A probe guard used for inspecting electrical characteristics of an inspection object, comprising:
a plurality of probes; and
at least one guide plate, wherein
a plurality of through-holes through which the probes penetrate are formed in the guide plate, and
the probe includes:
a columnar conductor; and
a plurality of insulating coating materials arranged spaced apart from each other on a surface of the conductor along a central axis direction of the conductor.
